(19)

Europäisches
Patentamt

European
Patent Office

Office européen
des brevets

(11)  **EP 4 052 954 A1**

(12)  **EUROPEAN PATENT APPLICATION**

(43) Date of publication:
**07.09.2022  Bulletin 2022/36**

(21) Application number: **22156395.0**

(22) Date of filing: **11.02.2022**

(51) International Patent Classification (IPC):
**B60L 53/14** $^{(2019.01)}$    **H01H 47/00** $^{(2006.01)}$

(52) Cooperative Patent Classification (CPC):
**B60L 53/14**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority:  **01.03.2021  CN 202110223636**

(71) Applicant: **Sungrow Power Supply Co., Ltd.
Hefei, Anhui 230088 (CN)**

(72) Inventors:
- ZHANG, Lei
  Hefei, 230088 (CN)
- DING, Zengfu
  Hefei, 230088 (CN)
- YANG, Yuefeng
  Hefei, 230088 (CN)

(74) Representative: **Zacco Norway AS
P.O. Box 488 Skøyen
0213 Oslo (NO)**

(54)  **DETECTION CIRCUIT, DETECTION METHOD AND APPLICATION DEVICE**

(57)    A detection circuit, a detection method and an application device are provided, applicable to the technical field of direct current charging. The detection circuit includes a first detection module, a second detection module, and a third detection module. The first detection module is connected in series to the third detection module to form a series branch. The series branch is connected between output terminals of a positive bus switch and a negative bus switch. A first end of the second detection module is connected to a node at which the first detection module is connected in series to the third detection module. A second end of the second detection module is connected to an input terminal of the positive bus switch or an input terminal of the negative bus switch. The conductive states of the first detection module and the third detection module are controllable. A connection relationship between the detection modules can be changed according to an on-off state of the bus switch and the control of conductive states of the first and third detection modules, thereby changing a voltage across each detection module. The detection circuit has a simpler structure.

FIG. 1

EP 4 052 954 A1

**Description**

**FIELD**

The present application relates to the technical field of direct current charging, and in particular to a detection circuit, a detection method and an application device.

**BACKGROUND**

In the conventional technology, a direct current charging pile includes a direct current bus configured to output electric energy to the electric vehicle. The direct current bus is connected in series to a bus switch including a positive bus switch and a negative bus switch. Correspondingly, an interface switch is arranged in a charging interface of the electric vehicle. When the charging interface in the electric vehicle is connected to the direct current charging pile, a power battery of the electric vehicle may be recharged via the direct current charging pile under the control of the cooperation of the bus switch and the interface switch.

According to relevant industry standards in the field of new energy vehicles, before the electric vehicle is charged, a battery voltage of the power battery needs to be measured. Further, the adhesion of the bus switch also needs to be detected, so as to ensure reliable progress of charging.

To meet the requirements, most existing direct current charging piles include an adhesion detection circuit and a battery voltage measurement circuit. However, it is found from research that adhesion detection of the bus switch has a similar fundamental as the measurement of the battery voltage. The adhesion detection circuit and the battery voltage measurement circuit are both arranged, increasing production cost of the direct current charging pile.

**SUMMARY**

A detection circuit, a detection method and an application device are provided according to the present application, in which a switch adhesion detection and a battery voltage measurement are performed by the same detection circuit. In this way, the circuit structure is simplified, and the number of detection circuits is reduced, therefore reducing the production cost of a direct current charging pile.

In order to achieve the above objectives, the technical solutions according to the present application are as follows.

In a first aspect, a detection circuit is provided according to the present application. The detection circuit includes a first detection module, a second detection module, and a third detection module.

The first detection module is connected in series to the third detection module to form a series branch.

The series branch is connected between an output terminal of a positive bus switch and an output terminal of a negative bus switch.

A first end of the second detection module is connected to a node at which the first detection module is connected in series to the third detection module.

A second end of the second detection module is connected to an input terminal of the positive bus switch or an input terminal of the negative bus switch.

Conductive states of the first detection module and the third detection module are controllable.

In an embodiment, the first detection module is connected to the output terminal of the positive bus switch. The second detection module is connected to the input terminal of the negative bus switch. The third detection module is connected to the output terminal of the negative bus switch.

In an embodiment, the first detection module is connected to the output terminal of the negative bus switch. The second detection module is connected to the input terminal of the negative bus switch. The third detection module is connected to the output terminal of the positive bus switch.

In an embodiment, the first detection module is connected to the output terminal of the negative bus switch. The second detection module is connected to the input terminal of the positive bus switch. The third detection module is connected to the output terminal of the positive bus switch.

In an embodiment, the first detection module includes a first sampling resistor, a first voltage dividing circuit and a detection switch. The first sampling resistor, the first voltage dividing circuit and the detection switch are connected in series. The second detection module includes a second sampling resistor and a second voltage dividing circuit that are connected in series. The third detection module includes a third voltage dividing circuit and a voltage dividing switch that are connected in series.

In an embodiment, the first detection module includes a fourth voltage dividing circuit and a detection switch that are connected in series. The second detection module includes a third sampling resistor and a fifth voltage dividing circuit that are connected in series. The third detection module includes a sixth voltage dividing circuit and a voltage dividing switch that are connected in series.

In an embodiment, the first detection module includes a fourth sampling resistor, a seventh voltage dividing circuit, and a detection switch. The fourth sampling resistor, the seventh voltage dividing circuit, and the detection switch are connected in series. The second detection module includes an eighth voltage dividing circuit. The third detection module includes a ninth voltage dividing circuit and a voltage dividing switch that are connected in series.

In an embodiment, the detection circuit according to the first aspect of the application further includes a selection switch.

A first terminal of the selection switch is connected to the node at which the first detection module is connected in series to the third detection module. A second terminal of the selection switch is connected to a protection ground.

In an embodiment, the node at which the first detection module is connected in series to the third detection module serves as reference ground, and the first terminal of the selection switch is connected to a source ground.

In an embodiment, the detection circuit according to the first aspect of the application further includes: at least one voltage acquisition circuit configured to acquire a voltage of a detection module.

In an embodiment, the detection circuit according to the first aspect of the application further includes a controller. The controller is connected to the first detection module, the third detection module, and the voltage acquisition circuit. The controller is configured to: control a conductive state of the first detection module, a conductive state of the third detection module, an on-off state of the positive bus switch and an on-off state of the negative bus switch; and perform a detection based on a detection voltage fed back by the voltage acquisition circuit.

In a second aspect, a detection method is provided according to the present application. The method is applied to the detection circuit according to any one of the first aspect of the application. The method includes:

acquiring a detection instruction, where the detection instruction indicates a project to be detected;

controlling, in response to the detection instruction, a bus switch and the detection circuit to be in a conductive state corresponding to the project to be detected;

acquiring a detection voltage of a target detection module, where the target detection module includes at least one of the first detection module and the second detection module in the detection circuit; and

performing a detection on the project to be detected, based on the detection voltage and a connection relationship between detection modules in the detection circuit.

In an embodiment, the project to be detected includes an insulation detection for a direct current bus, an adhesion detection for a bus switch, and a voltage measurement of a power battery.

In a third aspect, a charging pile is provided according to the present application. The charging pile includes at least one charging module and at least one detection circuit according to any one of the first aspect of the present application.

The charging module includes a charging circuit, a direct current bus, a positive bus switch, and a negative bus switch. The charging circuit, the direct current bus, the positive bus switch, and the negative bus switch are connected in series.

The detection circuit is connected to the charging module.

In an embodiment, the charging pile includes multiple charging modules, and a power distribution switch is arranged between the charging modules. Each of the multiple charging modules and the power distribution switch is provided with a detection circuit.

In an embodiment, for one charging module of the multiple charging modules, a detection circuit connected to the charging module and a detection circuit corresponding to a power distribution switch connected to the charging module share a detection module.

In an embodiment, the detection circuit does not include a selection switch, in a case that only adhesion detection is performed.

In a fourth aspect, a charging station is provided according to the present application. The charging station includes a transformer, a system controller, and at least one charging pile according to the third aspect of the application.

An input side of the transformer is connected to an alternating current power grid. An output side of the transformer is connected to the at least one charging pile.

The system controller is connected to the at least one charging pile, and is configured to control an operation state of the at least one charging pile.

In the detection circuit according to the present application, the first detection module is connected in series to the third detection module to form a series branch. The series branch is connected between an output terminal of a positive bus switch and an output terminal of a negative bus switch. A first end of the second detection module is connected to a node at which the first detection module is connected in series to the third detection module. A second end of the second detection module is connected to an input terminal of the positive bus switch or an input terminal of the negative bus switch. Conductive states of the first detection module and the third detection module each are controllable.

When the adhesion detection for the positive bus switch and the negative bus switch is performed by the detection circuit according to the present application, a detection personnel can change a connection relationship between the detection modules according to an on-off state of the bus switch and the control of conductive states of the first detection module and the third detection module, thereby changing a voltage across each detection module. Correspondingly, it is determined whether the bus switch is effectively active, that is, whether adhesion occurs, based on a voltage fed back from the detection module. Further, the first detection module and the second detection module are arranged downstream of the bus switch. When the bus switch is off and the charging pile is connected to a power battery, the first detection module and the third detection module are directly used to measure a battery voltage of the power battery. Therefore, the detection circuit of the present application can perform both the switch adhesion detection and the battery voltage measurement, which has a simpler structure compared with the conventional technology, thereby reducing the number of detection circuits and decreasing production cost of the direct current charging pile.

## BRIEF DESCRIPTION OF THE DRAWINGS

In order to more clearly illustrate technical solutions in embodiments of the present application or in the conventional technology, the drawings to be used in the description of the embodiments or the conventional technology are briefly described below. Apparently, the drawings in the following description show only some embodiments of the present application, and other drawings may be obtained by those skilled in the art from the drawings without any creative work.

FIG. 1 is a structural block diagram of a detection circuit according to an embodiment of the present application;

FIG. 2 is a structural block diagram of a detection circuit according to another embodiment of the present application;

FIG. 3 is a structural block diagram of a detection circuit according to another embodiment of the present application;

FIG. 4 is a structural block diagram of a detection circuit according to another embodiment of the present application;

FIG. 5 is a structural block diagram of a detection circuit according to another embodiment of the present application;

FIG. 6 is a flowchart of a detection method according to an embodiment of the present application;

FIG. 7 is a schematic diagram showing a circuit topology of a detection circuit according to an embodiment of the present application;

FIG. 8 is a schematic diagram showing a circuit topology of a detection circuit according to another embodiment of the present application;

FIG. 9 is a schematic diagram showing a circuit topology of a detection circuit according to another embodiment of the present application;

FIG. 10 is a schematic diagram showing a circuit topology of a detection circuit according to another embodiment of the present application;

FIG. 11 is a schematic diagram showing a circuit topology of a detection circuit according to another embodiment of the present application;

FIG. 12 is a schematic diagram showing a circuit topology of a detection circuit according to another embodiment of the present application;

FIG. 13 is a schematic diagram showing a circuit topology of a detection circuit according to another embodiment of the present application;

FIG. 14 is a structural block diagram of a charging pile according to an embodiment of the present application; and

FIG. 15 is a structural block diagram of a charging pile according to another embodiment of the present application.

## DETAILED DESCRIPTION OF EMBODIMENTS

The technical solutions in the embodiments of the present application are described clearly and completely in conjunction with the drawings in the embodiments of the present application hereinafter. It is apparent that the described embodiments are only some rather than all embodiments of the present application. All other embodiments obtained by those skilled in the art based on the embodiments of the present application without any creative work fall within the protection scope of the present application.

A detection circuit according to an embodiment of the present application includes a first detection module, a second detection module, and a third detection module.

The first detection module is connected in series to the third detection module to form a series branch. The series branch is connected between an output terminal of a positive bus switch and an output terminal of a negative bus switch. In embodiments of the present application, the positive bus switch refers to a bus switch connected in series to a positive direct current bus of a direct current charging pile. The negative bus switch refers to a bus switch connected in series to a negative direct current bus of the direct current charging pile. An input terminal of a bus switch refers to a connection terminal close to a charging circuit in the direct current charging pile. An output terminal of a bus switch refers to a connection terminal close to a power battery.

A first end of the second detection module is connected to a node at which the first detection module is connected in series to the third detection module. A second end of the second detection module is connected to an input terminal of the positive bus switch. Alternatively, the second end of the second detection module is connected to an input terminal of the negative bus switch.

Further, the conductive states of the first detection module and the third detection module are controllable. In an embodiment, the first detection module and the third detection module can in a conductive state or a nonconductive state, based on detection requirements. The first detection module in the conductive state has a first resistance, and the third detection module in the conductive state has a second resistance. The second detection module always has third resistance.

It should be noted that, for ease of description, the detection switch mentioned in the subsequent description refers to one or more of the first detection module, the second detection module, and the third detection module in the detection circuit according to the present application. The positive bus switch and the negative bus switch are referred to as a bus switch for short. Based on the foregoing, in the detection circuit according to the present application, each detection module is connected to a bus switch in various modes, corresponding to various circuit structures.

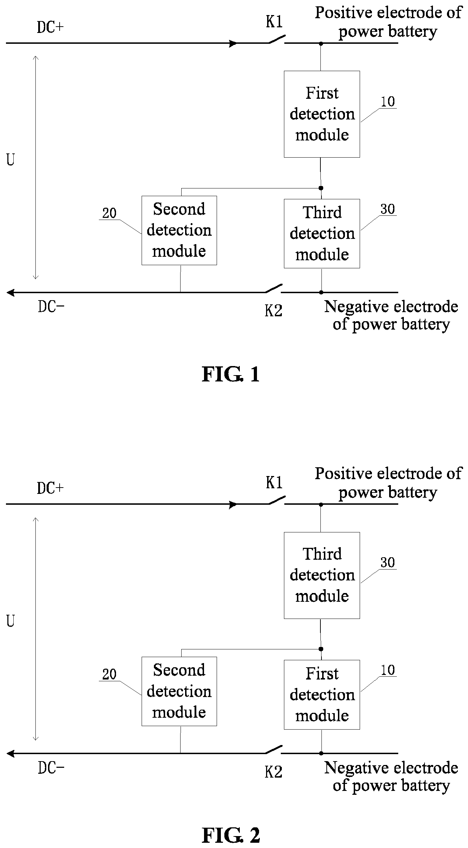

In an embodiment, reference is made to FIG. 1, which is a structural block diagram of a detection circuit according to an embodiment of the present application. In this embodiment, the first detection module 10 is connected in series to the third detection module 30. The first detection module 10 is connected to an output terminal of the positive bus switch K1. The third detection module 30 is connected to an output terminal of the negative bus switch K2.

The second detection module 20 is connected to an input terminal of the negative bus switch K2.

In an embodiment, reference is made to FIG. 2, which is a structural block diagram of a detection circuit according to another embodiment of the present application. In this embodiment, the first detection module 10 is connected in series to the third detection module 30. The first detection module 10 is connected to an output terminal of the negative bus switch K2. The third detection module 30 is connected to an output terminal of the positive bus switch K1.

The second detection module 20 is connected to an input terminal of the negative bus switch K2.

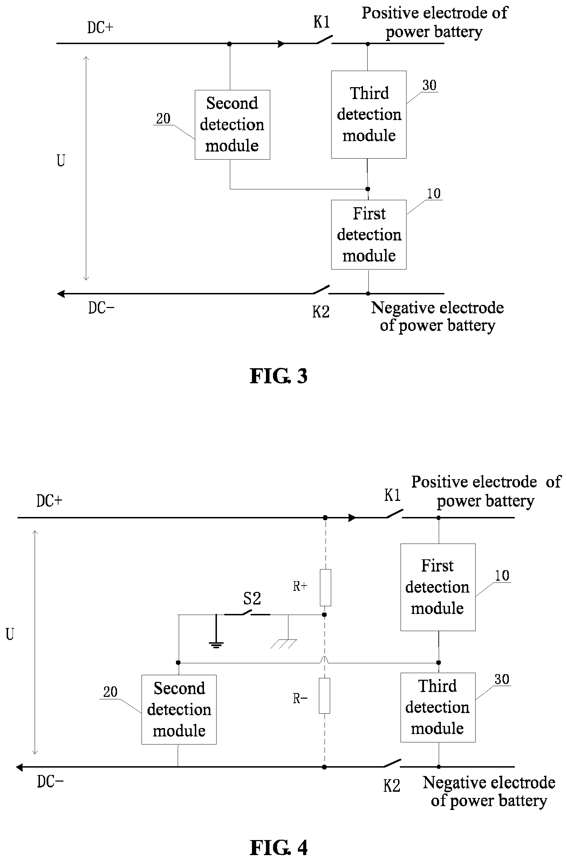

In an embodiment, reference is made to FIG. 3, which is a structural block diagram of a detection circuit according to another embodiment of the present application. In this embodiment, the first detection module 10 is connected in series to the third detection module 30. The first detection module 10 is connected to an output terminal of the negative bus switch K2. The third detection module 30 is connected to an output terminal of the positive bus switch K1.

The second detection module 20 is connected to an input terminal of the positive bus switch K1.

Based on the structural block diagram of the detection circuit according to any one of the foregoing embodiments, when an adhesion detection for the positive bus switch and the negative bus switch is performed by the detection circuit according to the present application, a detection personnel can change a connection relationship between the detection modules according to an on-off state of the bus switch and the control of conductive states of the first detection module and the third detection module, thereby changing a voltage across each detection module. Correspondingly, it is determined whether the bus switch is effectively active, that is, whether adhesion occurs, based on a voltage fed back from the detection module. Further, the first detection module and the second detection module are arranged downstream of the bus switch. When the bus switch is off and the charging pile is connected to a power battery, the first detection module and the third detection module are directly used to measure a battery voltage of the power battery. Therefore, the detection circuit of the present application can perform both the switch adhesion detection and the battery voltage measurement, which has a simpler structure compared with the conventional technology, thereby reducing the number of detection circuits and decreasing production cost of the direct current charging pile.

Further, in an actual application of the direct current charging pile, it is also required to perform an insulation test on the direct current charging pile. The insulation test is based on principles similar to the adhesion detection in any of the foregoing embodiments. Therefore, based on the above-mentioned embodiments, a detection circuit capable of performing an insulation test, an adhesion detection, and a voltage measurement for a power battery is provided according to the present application.

In an embodiment, reference is made to FIG. 4, which is a structural block diagram of a detection circuit according to another embodiment of the present application. Based on the embodiment shown in FIG. 1, the detection circuit according to this embodiment further includes a selection switch S2. A first terminal of the selection switch S2 is connected to the node at which the first detection module 10 is connected in series to the third detection module 30. A second terminal of the selection switch S2 is connected to a protection ground.

As shown in Figure 4, R+ represents an insulation resistor between the positive direct current bus DC+ and the protection ground, and R- represents an insulation resistor between the negative direct current bus DC- and the protection ground. Further, in the embodiment shown in FIG. 4, the first terminal of the selection switch S2 is connected to a source ground, so that the node at which the first detection module 10 is connected in series to the third detection module 30 serves as a reference ground in the subsequent calculation of the voltage.

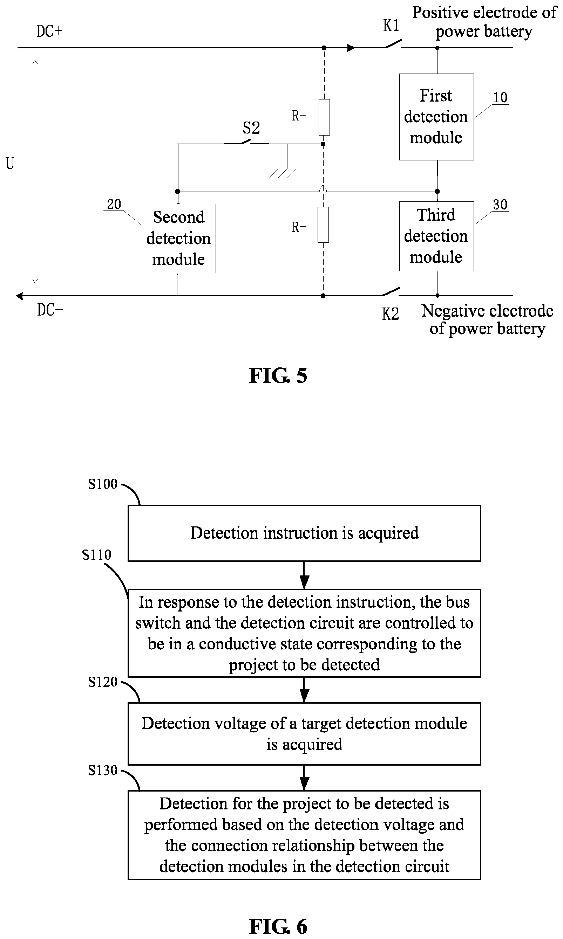

In an embodiment, reference is made to FIG. 5, which is a structural block diagram of a detection circuit according to another embodiment of the present application. In the embodiment shown in FIG. 5, the first terminal of the selection switch S2 is not connected to a source ground. In this case, the negative direct current bus DC- serves as the reference ground in the subsequent calculation of the voltage.

It should be noted that the reference ground is set depending on actual test requirements. In addition, the selection switch is also applicable to the embodiments shown in FIGs. 2 and 3, as well as other structures of the detection circuit proposed based on the core idea of the present application, so as to perform insulation test based on the on-off state of the bus switch and the connection relationship between the detection modules. Therefore, changes to the circuit structure made within the scope of the core idea of the present application should fall within the protection scope of the present application.

In an embodiment, for convenience of the detection circuit, at least one voltage acquisition circuit for acquiring a voltage across a detection module is further provided in the detection circuit. A detection voltage of a detection module is directly acquired by the voltage acquisition circuit, so as to further improve detection efficiency.

The detection circuit according to any of the foregoing embodiments further includes a controller. The controller is connected to the first detection module, the third detection module, and the voltage acquisition circuit. The controller is configured to control the conductive states of the first detection module and the third detection module, and the on-off states of the positive bus switch and the negative bus switch, in the detection process, and perform the detection based on the detection voltage fed back by the voltage acquisition circuit.

Based on the detection circuit according to the foregoing embodiments, a detection method is provided according to the present application, to perform the insulation test, the adhesion detection, and the voltage measurement of the power battery by controlling the conductive state of the detection circuit and the on-off state of the bus switch. This method is applicable to the controller in the above-mentioned detection circuit. In a case that no controller is provided in the detection circuit, the method is applicable to a controller in the direct current charging pile.

In an embodiment, reference is made to FIG. 6, which is a flowchart of a detection method according to an embodiment of the present application. In this embodiment, the method includes the following steps S100 to S130.

In S100, a detection instruction is acquired.

In an actual application, the detection instruction is transmitted from a control system of the direct current charging pile. The control system transmits the detection instruction when the direct current charging pile is powered on, connected to an object to be charged, or when other relevant detection is required under industry regulations. A project to be detected is indicated through the detection instruction.

It should be noted that, a form of the detection instruction, a manner of indicating the project to be detected, and a source of the detection instruction may refer to the conventional technology, which are not limited in the present application.

The project to be detected includes an insulation test of a direct current bus, an adhesion detection for a bus switch, and a voltage measurement of a power battery. In practice, the detection instruction indicates one or more of the insulation test for the direct current bus, the adhesion detection for the bus switch, and the voltage measurement of the power battery.

In S110, in response to the detection instruction, the bus switch and the detection circuit are controlled to be in a conductive state corresponding to the project to be detected.

It can be seen from the structure of the detection circuit according to the foregoing embodiments, the structure of the detection circuit has different structures when different projects to be detected is performed. In addition, when a project to be detected is performed, the detection modules in the detection circuit are controlled to be in respective states, so as to control detection modules in the detection circuit to be connected in series or parallel. For a determined project to be detected, the detection circuit has a corresponding conductive state according to each embodiment. The conductive state depends on the circuit structure. After the project to be detected and a structure of the detection circuit are determined, the conductive state of the bus switch and the on-off state of the detection circuit are determined in the detection process.

In S120, a detection voltage of a target detection module is acquired.

The target detection module is at least one of the first detection module and the second detection module in the detection circuit. After the bus switch and the detection circuit are controlled to be in the state corresponding to the project to be detected, the detection voltage of the target detection module is acquired.

In S130, a detection for the project to be detected is performed based on the detection voltage and the connection relationship between the detection modules in the detection circuit.

After the detection voltage is acquired, the detection for the project to be detected is performed based on the acquired detection voltage and the connection relationship between the detection modules in the detection circuit.

An implementation of the above detection method is illustrated below based on the structure of the detection circuit.

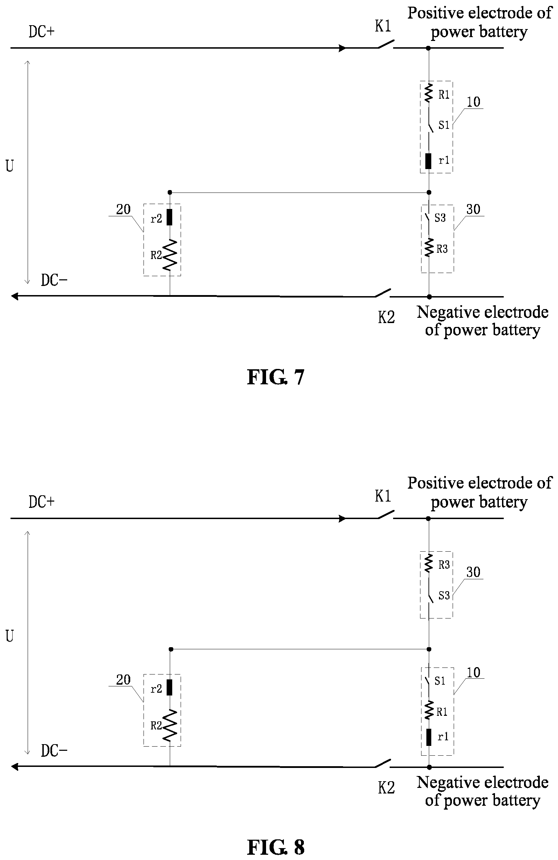

In an embodiment, reference is made to FIG. 7, which is a schematic diagram showing a circuit topology of a detection circuit according to an embodiment of the present application. In the detection circuit according to this embodiment, the first detection module 10 includes a first sampling resistor r1, a first voltage dividing circuit R1, and a detection switch S1. The first sampling resistor r1, the first voltage dividing circuit R1, and the detection switch S1 are connected in series. The second detection module 20 includes a second sampling resistor r2 and a second voltage dividing circuit R2 that are connected in series. The third detection module 30 includes a third voltage dividing circuit R3 and a voltage dividing switch S3 that are connected in series.

The adhesion detection for the bus switches K1 and K2 performed by the detection circuit shown in FIG. 7 includes the following steps.

In a first step, the detection switch S1 is switched on and the voltage dividing switch S3 is switched off. In a case that the bus switch K1 is switched off, if there is a voltage across the first sampling resistor r1 or a voltage across the second sampling resistor r2 (the voltage reflects a relationship of voltage division among the first voltage dividing circuit R1, the second voltage dividing circuit R2, the first sampling resistor r1 and the second sampling resistor r2), an adhesion of the positive bus switch K1 occurs. Otherwise, the adhesion of the positive bus switch K1 does not occur.

In a second step, if there is no voltage across the first sampling resistor r1 or across the second sampling resistor r2, the positive bus switch K1 is switched on.

In a third step, the negative bus switch K2 is controlled to be switched off, and the voltage dividing switch S3 is controlled to be switched on. If the voltage across the first sampling resistor r1 reflects the relationship among the first voltage dividing circuit R1, the second voltage dividing circuit R2, the first sampling resistor r1 and the second sampling resistor r2, it is indicated that the adhesion of the negative bus switch K2 does not occur. If the voltage across the first sampling resistor r1 or across the second sampling resistor r2 reflects the voltage division among the first voltage dividing circuit R1, the second voltage dividing circuit R2, the first sampling resistor r1, the second sampling resistor r2, and the third voltage dividing circuit R3, it is indicated that an adhesion of the negative bus switch K2 occurs.

In an embodiment, reference is made to FIG. 8, which is a schematic diagram showing a circuit topology of a detection circuit according to another embodiment of the present application. In the detection circuit according to this embodiment, the detection modules have the same respective structures as the embodiment shown in FIG. 7, which will not described in detail herein.

The adhesion detection for the bus switches K1 and K2 performed by the detection circuit shown in FIG. 8 includes the following steps.

In a first step, the detection switch S1 is switched off, and the voltage dividing switch S3 is switched on. In the case that the positive bus switch K1 is switched off, if there is a voltage across the second sampling resistor r2 (the voltage reflects voltage division among the third voltage dividing circuit R3, the second voltage dividing circuit R2, and the second sampling resistor r2), it is indicated that the adhesion of the positive bus switch K1 occurs. Otherwise, it is indicated that the adhesion of the positive bus switch K1 does not occur.

In a second step, if there is no voltage across the second sampling resistor r2, the positive bus switch K1 is controlled to be switched on, and the negative bus switch K2 is controlled to be switched off.

In a third step, the detection switch S1 and the voltage dividing switch S3 are controlled to be switched on. If the voltage across the first sampling resistor r1 or the voltage across the second sampling resistor r2 reflects a relationship among the second voltage dividing circuit R2, the third voltage dividing circuit R3, and the second sampling resistor r2, it is indicated that the adhesion of the negative bus switch K2 does not occur. If the voltage across the first sampling resistor r1 or the voltage across the second sampling resistor r2 reflects a relationship among the first voltage dividing circuit R1, the second voltage dividing circuit R2, the first sampling resistor r1, the second sampling resistor r2, and the third voltage dividing circuit R3, it is indicated that the adhesion of the negative bus switch K2 occurs.

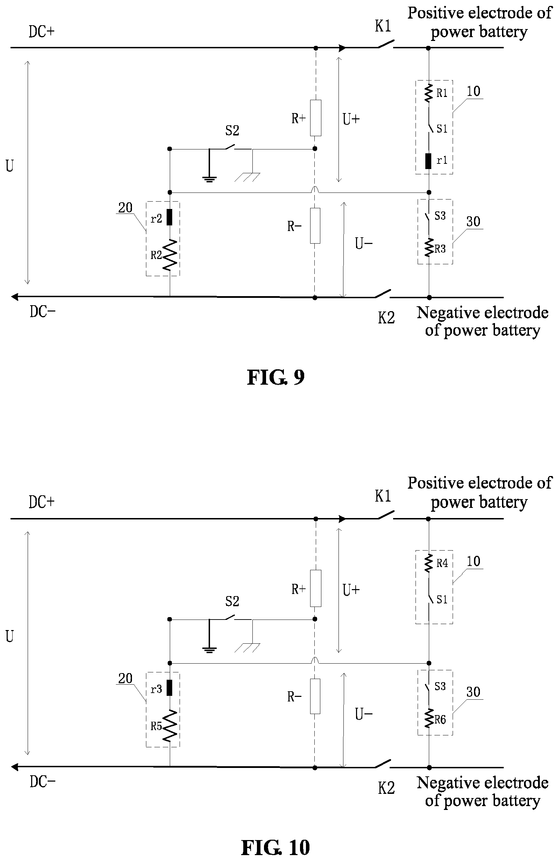

In an embodiment, reference is made to FIG. 9, which is a schematic diagram showing a circuit topology of a detection circuit according to another embodiment of the present application. Based on the embodiment shown in FIG. 7, the detection circuit according to this embodiment shown in FIG. 9 further includes a selection switch S2. In the case that the selection switch S2 is switched off, the adhesion detection of the bus switch can be performed based on the embodiment shown in FIG. 9. The specific detection process may refer to the foregoing embodiments. The insulation detection performed based on the embodiment shown in FIG. 9 is described below.

In a first step, the positive bus switch K1 and the negative bus switch K2 are controlled to be switched on. The direct current charging pile is controlled to output a detection voltage U.

In a second step, the first detection module 10 is controlled to be conductive. That is, the detection switch S1 is controlled to be switched on. A ratio of a voltage U+ across the insulation resistor R+ to a voltage U- across the insulation resistor R- is expressed as the following equation A1.

$$\frac{U_+}{U_-} = \frac{R_+//(R1+r1)}{R_-//(R2+r2)} \qquad \text{Equation A1}$$

In a third step, the first detection module 10 and the second detection module 20 are controlled to be conductive. That is, the detection switch S1 and the voltage division switch S3 are controlled to be switched on. Further, the selection switch S2 is controlled to be switched on. A ratio of a voltage $U'_+$ across the insulation resistor R+ to a voltage $U'_-$ across the insulation resistor R- is expressed as the following equation A2.

$$\frac{U'_+}{U'_-} = \frac{R_+//(R1+r1)}{R_-//(R2+r2)//R3} \qquad \text{Equation A2}$$

In a fourth step, resistance of the insulation resistor R+ and resistance of the insulation resistor R- are calculated by combining equations A1 and A2. Thus, insulation resistance is obtained, and the insulation detection is completed.

In an embodiment, reference is made to FIG. 10, which is a schematic diagram showing a circuit topology of a detection circuit according to another embodiment of the present application. This embodiment is a simplification of the embodiment shown in FIG. 9. In this embodiment, the first detection module 10 includes a fourth voltage dividing circuit R4 and a detection switch S1 that are connected in series. The second detection module 20 includes a third sampling resistor r3 and a fifth voltage dividing circuit R5 that are connected in series. The third detection module 30 includes a sixth voltage dividing circuit R6 and a voltage dividing switch S3 that are connected in series.

As shown in FIG. 10, U represents a bus voltage, which can be obtained from an external circuit or from control information of an upper-level control system. Alternatively, the bus voltage U is calculated based on a loop formed of R4-S1-r3-R5. The insulation detection performed by the detection circuit shown in FIG. 10 includes the following steps.

In a first step, the selection switch S2, the positive bus switch K1 and the negative bus switch K2 are switched on. The detection switch S1 and the voltage dividing switch S3 are switched off. A ratio of voltages is expressed as the following equation B1.

$$\frac{U-U_2}{U_2} = \frac{R_+}{R_-//(R_5+r3)} \qquad \text{Equation B1}$$

In the equation B1, U2 represents a voltage across the insulation resistor R- in the case that only the selection switch S2 is switched on.

In a second step, the selection switch S2, the detection switch S1, the positive bus switch K1, and the negative bus switch K2 are switched on. The voltage dividing switch S3 is switched off. A ratio of voltages is expressed as the following equation B2.

$$\frac{U-U_{22}}{U_{22}} = \frac{R_+//R_4}{R_-//(R_5+r3)} \qquad \text{Equation B2}$$

In the equation B2, U22 represents a voltage across the insulation resistor R- in the case that only the selection switch S2 and the detection switch S1 are switched on.

In a third step, the selection switch S2, the detection switch S1, the voltage dividing switch S3, the positive bus switch K1 and the negative bus switch K2 are switched on. A ratio of voltages is expressed as the following equation B3.

$$\frac{U - U_{23}}{U_{23}} = \frac{R_+//R_4}{R_-//(R_5 + r3)//R6} \qquad \text{Equation B3}$$

In the equation B3, U23 represents a voltage across the insulation resistor R- in the case that the voltage dividing switch S3, the selection switch S2 and the detection switch S1 are switched on.

In a fourth step, resistance of the insulation resistor R+ and resistance of the insulation resistor R- are calculated by combining two of the equations B1, B2, and B3, and the insulation detection is completed.

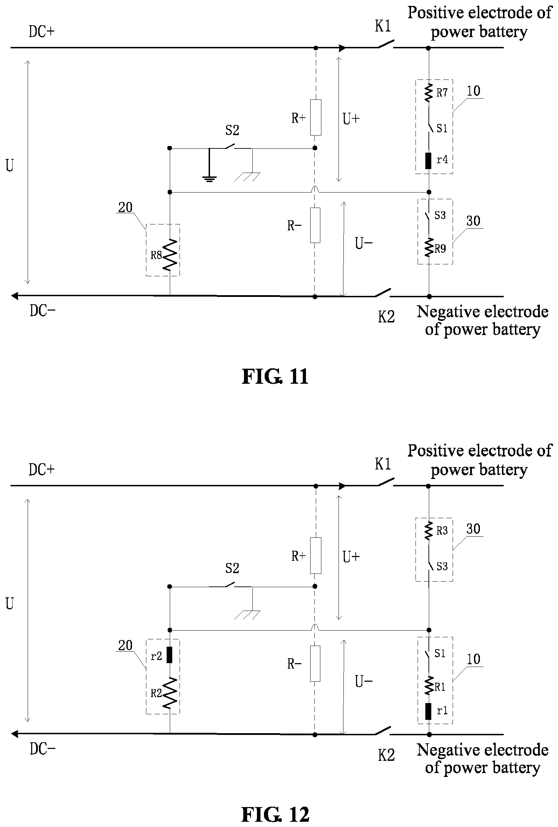

In an embodiment, reference is made to FIG. 11, which is a schematic diagram showing a circuit topology of a detection circuit according to another embodiment of the present application. This embodiment is also a simplification of the embodiment shown in FIG. 9. In this embodiment, the first detection module 10 includes a fourth sampling resistor r4, a seventh voltage dividing circuit R7, and a detection switch S1. The fourth sampling resistor r4, the seventh voltage dividing circuit R7, and the detection switch S1 are connected in series. The second detection module 20 includes an eighth voltage dividing circuit R8. The third detection module 30 includes a ninth voltage dividing circuit R9 and a voltage dividing switch S3 that are connected in series. The insulation detection performed by the detection circuit according to the embodiment shown in FIG. 11 includes the following steps.

In a first step, the selection switch S2, the detection switch S1, the positive bus switch K1, and the negative bus switch K2 are switched on. The voltage dividing switch S3 is switched off. A ratio of voltages is expressed as the following equation C1.

$$\frac{U - U_1}{U_1} = \frac{R_+//(R_7 + r4)}{R_-//R_8} \qquad \text{Equation C1}$$

The bus voltage U may be obtained based on the embodiment shown in FIG. 10, which will not be repeated herein. U1 represents a voltage across the insulation resistor R- in the case that the selection switch S2 and the detection switch S1 are switched on.

In a second step, the selection switch S2, the detection switch S1, the voltage dividing switch S3, the positive bus switch K1 and the negative bus switch K2 are switched on. A ratio of voltages is expressed as the following equation C2.

$$\frac{U - U_{11}}{U_{11}} = \frac{R_+//(R_7 + r4)}{R_-//R8//R9} \qquad \text{Equation C2}$$

In the equation C2, U11 represents a voltage across the insulation resistor R-, in the case that the voltage dividing switch S3, the selection switch S2 and the detection switch S1 are switched on.

In a third step, resistance of the insulation resistor R+ and resistance of the insulation resistor R- are calculated by combining equations C1 and C2, and the insulation detection is completed.

In an embodiment, reference is made to FIG. 12, which is a schematic diagram showing a circuit topology of a detection circuit according to another embodiment of the present application. In the detection circuit according to this embodiment shown in FIG. 12, the detection modules have the same respective structures as the embodiment shown in FIG. 9, and the connection between each detection module and the bus switch is different from that in the embodiment shown in FIG. 9. The insulation detection performed by the detection circuit according to the embodiment shown in FIG. 12 includes the following steps.

In a first step, the positive bus switch K1 and the negative bus switch K2 are controlled to be switched on. The direct current charging pile is controlled to output a detection voltage U.

In a second step, the selection switch S2 and the voltage dividing switch S3 are controlled to be switched on. The detection switch S1 is controlled to be switched off. A ratio of a voltage U+ across the insulation resistor R+ to a voltage U- across the insulation resistor R- is expressed as the following equation D1.

$$\frac{U_+}{U_-} = \frac{R_+//R3}{R_-//(R2 + r2)} \qquad \text{Equation D1}$$

In a third step, the detection switch S1, the selection switch S2 and the voltage dividing switch S3 are controlled to be switched on. A ratio of the voltage $U'_+$ across the insulation resistor R+ to the voltage $U'_-$ across the insulation resistor R- is expressed as the following equation D2.

$$\frac{U'_+}{U'_-} = \frac{R_+//R3}{R_-//(R2 + r2)//(R1 + r1)} \qquad \text{Equation D2}$$

In a fourth step, resistance of the insulation resistor R+ and resistance of the insulation resistor R- are calculated by combining equations D1 and D2, and the insulation detection is completed.

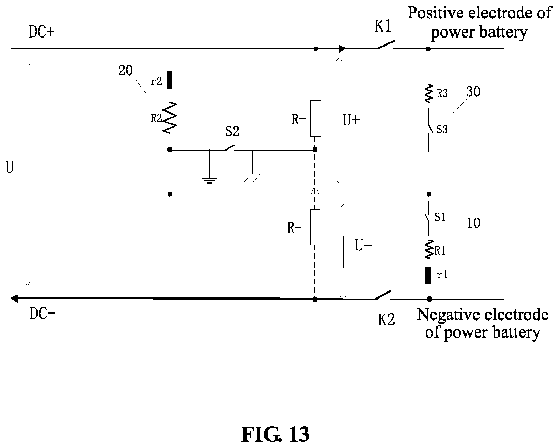

In an embodiment, reference is made to FIG. 13, which is a schematic diagram showing a circuit topology of a detection circuit according to another embodiment of the present application. In the detection circuit according to this embodiment shown in FIG. 13, the detection modules have the same respective structures as the embodiment shown in FIG. 9, and the connection between each detection module and the bus switch is different from that in the embodiment shown in FIG. 9. The insulation detection performed by the detection circuit according to the embodiment shown in FIG. 13 includes the following steps.

In a first step, the positive bus switch K1 and the negative bus switch K2 are controlled to be switched on. The direct current charging pile is controlled to output a detection voltage U.

In a second step, the selection switch S2 and the voltage dividing switch S3 are controlled to be switched on. The detection switch S1 is controlled to be switched off. A ratio of a voltage U+ across the insulation resistor R+ to a voltage U- across the insulation resistor R- is expressed as the following equation E1.

$$\frac{U_+}{U_-} = \frac{R_+//R3//(R2 + r2)}{R_-} \qquad \text{Equation E1}$$

In a third step, the detection switch S1, the selection switch S2 and the voltage dividing switch S3 are controlled to be switched on. A ratio of the voltage $U'_+$ across the insulation resistor R+ to the voltage $U'_-$ across the insulation resistor R- is expressed as the following equation E2.

$$\frac{U'_+}{U'_-} = \frac{R_+//R3//(R2 + r2)}{R_-//(R1 + r1)} \qquad \text{Equation E2}$$

In a fourth step, resistance of the insulation resistor R+ and resistance of the insulation resistor R- are calculated by combining equations E1 and E2, and the insulation detection is completed.

Further, the detection circuit according to any of the above embodiments is also capable of measuring a voltage of a power battery. When a power battery is connected to the output terminal of the bus switch, the positive bus switch K1 and the negative bus switch K2 are controlled to be switched off. If the detection circuit includes a selection switch S2, the selection switch S2 is also switched off. The first detection module and the third detection module are controlled to be conductive. The battery voltage is calculated based on a detection voltage fed back by the first detection module, and a known ratio between resistance of the first detection module and resistance of the third detection module.

In summary, the detection circuit according to any of embodiments of the present application is capable of perform two or more detection functions. Compared with the conventional technology, the number of components in the detection circuit is effectively reduced, the cost of the detection circuit is reduced, and design cost of the direct current charging pile is reduced.

In practice, the bus voltage of the charging pile is relatively high in the operation process. It is difficult to directly acquire a voltage across the first detection module or the second detection module. Therefore, in the above embodiments of the present application, a sampling resistor and a voltage dividing resistor are provided. A voltage across the sampling resistor is reduced by the voltage dividing resistor. Thus, the voltage of the sampling resistor can be acquired by a voltage sampling circuit according to the conventional technology. Further, a voltage of a detection module or other circuit is calculated, based on the ratio between the resistance of the sampling resistor and the resistance of the voltage dividing resistor, so as to meet actual calculation requirements.

A charging pile is also provided according to an embodiment of the present application. The charging pile includes at least one charging module and at least one detection circuit according to any one of the above embodiments.

Each charging module includes a charging circuit, a direct current bus, a positive bus switch, and a negative bus switch. The charging circuit, the direct current bus, the positive bus switch, and the negative bus switch are connected in series.

The detection circuit is connected to the charging module. The connection between components in the detection circuit and the charging module may refer to the foregoing embodiments, which will not be described in detail herein.

In practice, especially when a direct current charging pile includes two or more charging modules, a power distribution switch is arranged between the charging modules. Therefore, in an embodiment, a detection circuit is provided for each of the charging module and the power distribution switch, to perform detection at a corresponding position.

In an embodiment, for a direct current charging pile including multiple charging modules, it is impossible to perform insulation detection, adhesion detection, or battery voltage measurement on two objects (the charging module or the power distribution switch) simultaneously. Therefore, in order to further reduce cost of the direct current charging pile, detection circuits share a part of detection module. That is, for any charging module, a detection circuit connected to the charging module and a detection circuit corresponding to a power distribution switch connected to the charging module may share a detection module. Moreover, in the case that only adhesion detection is to be performed, the detection circuit includes no selection switch.

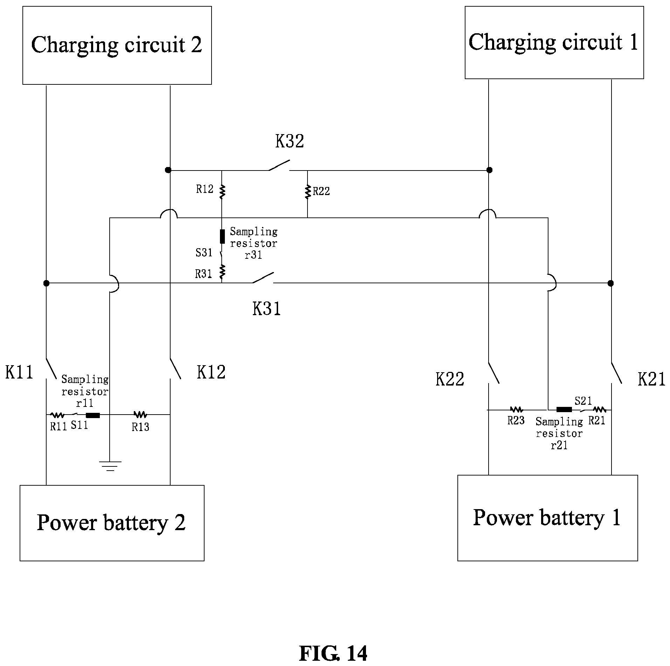

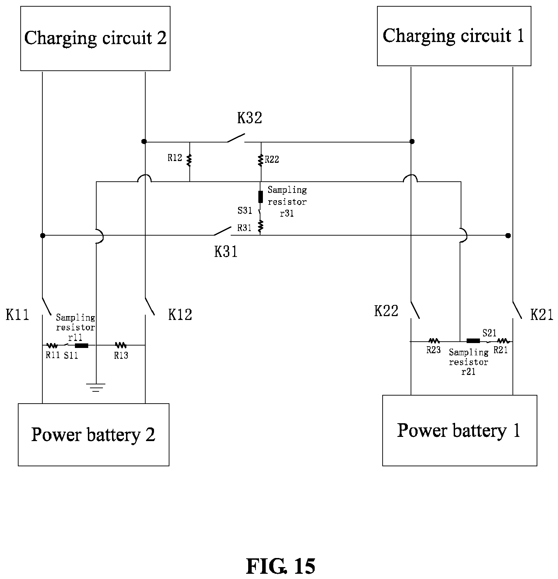

In an embodiment, FIG. 14 and 15 each show an embodiment in which detection circuits share a detection module.

The adhesion detection performed by the direct current charging pile shown in FIG. 14 is illustrated as follows.

1) R11, S11, r11, R13, and R12 are used to perform adhesion detection for K11 and K12.

Determination logic is as follows

A charging circuit 2 outputs a bus voltage U for the adhesion detection.

S11 is switched on and K11 is controlled to be switched off. If there is no voltage across a sampling resistor r11, it is indicated that the adhesion of K11 does not occur.

If a voltage across the sampling resistor r11 reflects voltage division among R11, r11, and R12, it is indicated that the adhesion of K11 occurs and the adhesion of K12 does not occur.

If a voltage across the sampling resistor r11 reflects voltage division among R11, r11, R12 and R13, it is indicated that the adhesion of K11 occurs and the adhesion of K12 occurs.

2) R21, S21, r21, R23, and R22 are configured to perform adhesion detection for K21 and K22.

A charging circuit 1 outputs a bus voltage U for the adhesion detection.

S21 is switched on. K21 is controlled to be switched off by software. If there is no voltage across a sampling resistor r21, it is indicated that the adhesion of K21 does not occur.

If a voltage across the sampling resistor r11 reflects voltage division among R21, r21, and R22, it is indicated that the adhesion of K21 occurs and the adhesion of K22 does not occur.

If a voltage across the sampling resistor r11 reflects voltage division among R21, r21, R22, and R23, it is indicated that the adhesion of K21 occurs and the adhesion of K22 occurs.

3) R31, S31, r31, R12, and R22 are configured to perform adhesion detection for K31 and K32.

The charging circuit 1 outputs a bus voltage U for the adhesion detection.

S31 is switched on. K31 is controlled to be switched off by software. If there is no voltage across the sampling resistor r31, it is indicated that the adhesion of K31 does not occur.

If a voltage across the sampling resistor r31 reflects voltage division among R31, r31, and R22, it is indicated that the adhesion of K31 occurs and the adhesion of K32 does not occur.

If a voltage across the sampling resistor r31 reflects voltage division among R31, r31, R22, and R12, it is indicated that the adhesion of K31 occurs and the adhesion of K32 occurs.

The adhesion detection performed by the direct current charging pile shown in FIG. 15 is illustrated as follows.

1) R11, S11, r11, R13, and R12 are configured to perform the adhesion detection for K11 and K12. The adhesion detection for K11 and K12 in the embodiment shown in FIG. 15 is the same as that in the embodiment shown in FIG. 14, which will not be repeated herein.

2) R21, S21, r21, R23, and R22 are configured to perform the adhesion detection for K21 and K22. The adhesion detection for K21 and K22 in the embodiment shown in FIG. 15 is the same as that in the embodiment shown in FIG. 14, which will not be repeated herein.

3) R31, S31, r31, R12, and R22 are configured to perform the adhesion detection for K31 and K32.

A charging circuit 2 outputs a bus voltage U for the adhesion detection.

S31 is switched on and K31 is controlled to be switched off. If there is no voltage across a sampling resistor r31, it is indicated that the adhesion of K31 does not occur.

If a voltage across the sampling resistor r31 reflects voltage division among R31, r31and R22, it is indicated that the adhesion of K31 occurs and the adhesion of K32 does not occur.

If a voltage across the sampling resistor r31 reflects voltage division among R31, r31, R32 and R12, it is indicated that the adhesion of K31 occurs and the adhesion of K32 occurs.

In the direct current charging pile according to the above embodiments of the present application, the adhesion detection is performed by the detection circuit. Thus, compared with adhesion detection performed based on an auxiliary contact of a bus switch according to the conventional technology, an accuracy of the detection result is improved. In addition, since a bus switch with an auxiliary contact is unnecessary, cost of the bus switch is reduced.

Further, an insulation detection is performed for the direct current charging pile, and a battery voltage of a power battery connected to a charging module is measured as required.

A charging station is further provided according to an embodiment of the present application. The charging station includes a transformer, a system controller, and at least one charging pile according to any one of the above embodiments.

An input side of the transformer is connected to an alternating current power grid. An output side of the transformer is connected to the at least one charging pile.

The system controller is connected to the charging pile, and is configured to control an operation state of each charging pile.

The embodiments in this specification are described in a progressive manner, and each focus on differences from other embodiments. The same or similar parts between embodiments can be referred to each other. Since the device disclosed in embodiments corresponds to the method disclosed in the embodiments, the description of the device is relatively simple, and for related parts, reference can be made to the description of the method.

Only preferred embodiments of the present application are described above, and the present application is not limited thereto. Although the present application is disclosed as above with preferred embodiments, which are not intended to limit the present application. Those skilled in the art may, based on the methods and technical solutions disclosed above and without departing from the scope of the technical solutions of the present application, make many changes and modifications to the technical solutions of the present application, or modify the technical solutions into equivalent embodiments. Therefore, any simple modifications, equivalent changes and modifications made to the above embodiments based on the technical essence of the present application without departing from the scope of the technical solutions of the present application still fall within the protection scope of the technical solutions of the present application.

**Claims**

1. A detection circuit, comprising: a first detection module, a second detection module, and a third detection module, wherein

   the first detection module is connected in series to the third detection module to form a series branch;
   the series branch is connected between an output terminal of a positive bus switch and an output terminal of a negative bus switch;
   a first end of the second detection module is connected to a node at which the first detection module is connected in series to the third detection module;
   a second end of the second detection module is connected to an input terminal of the positive bus switch or an input terminal of the negative bus switch; and
   conductive states of the first detection module and the third detection module are controllable.

2. The detection circuit according to claim 1, wherein

   the first detection module is connected to the output terminal of the positive bus switch;
   the second detection module is connected to the input terminal of the negative bus switch; and
   the third detection module is connected to the output terminal of the negative bus switch.

3. The detection circuit according to claim 1, wherein:

   the first detection module is connected to the output terminal of the negative bus switch;
   the second detection module is connected to the input terminal of the negative bus switch; and

the third detection module is connected to the output terminal of the positive bus switch.

4. The detection circuit according to claim 1, wherein

the first detection module is connected to the output terminal of the negative bus switch;
the second detection module is connected to the input terminal of the positive bus switch; and
the third detection module is connected to the output terminal of the positive bus switch.

5. The detection circuit according to claim 1, wherein

the first detection module comprises a first sampling resistor, a first voltage dividing circuit and a detection switch, wherein the first sampling resistor, the first voltage dividing circuit and the detection switch are connected in series;
the second detection module comprises a second sampling resistor and a second voltage dividing circuit that are connected in series; and
the third detection module comprises a third voltage dividing circuit and a voltage dividing switch that are connected in series.

6. The detection circuit according to claim 2, wherein

the first detection module comprises a fourth voltage dividing circuit and a detection switch that are connected in series;
the second detection module comprises a third sampling resistor and a fifth voltage dividing circuit that are connected in series; and
the third detection module comprises a sixth voltage dividing circuit and a voltage dividing switch that are connected in series.

7. The detection circuit according to claim 2, wherein

the first detection module comprises a fourth sampling resistor, a seventh voltage dividing circuit, and a detection switch, wherein the fourth sampling resistor, the seventh voltage dividing circuit, and the detection switch are connected in series;
the second detection module comprises an eighth voltage dividing circuit; and
the third detection module comprises a ninth voltage dividing circuit and a voltage dividing switch that are connected in series.

8. The detection circuit according to claim 1, further comprising: a selection switch, wherein

a first terminal of the selection switch is connected to the node at which the first detection module is connected in series to the third detection module; and
a second terminal of the selection switch is connected to a protection ground,
wherein in a case that the node at which the first detection module is connected in series to the third detection module serves as a reference ground, the first terminal of the selection switch is connected to a source ground.

9. The detection circuit according to any one of claims 1 to 8, further comprising:

at least one voltage acquisition circuit configured to acquire a voltage of a detection module; and
a controller, wherein
the controller is connected to the first detection module, the third detection module, and the voltage acquisition circuit; and
the controller is configured to: control a conductive state of the first detection module, a conductive state of the third detection module, an on-off state of the positive bus switch and an on-off state of the negative bus switch; and perform a detection based on a detection voltage fed back by the voltage acquisition circuit.

10. A detection method, applicable to the detection circuit according to any one of claims 1 to 9, wherein the method comprises:

acquiring a detection instruction, wherein the detection instruction indicates a project to be detected;

controlling, in response to the detection instruction, a bus switch and the detection circuit to be in a conductive state corresponding to the project to be detected;

acquiring a detection voltage of a target detection module, wherein the target detection module comprises at least one of the first detection module and the second detection module in the detection circuit; and

performing a detection on the project to be detected, based on the detection voltage and a connection relationship between detection modules in the detection circuit.

11. A charging pile, comprising: at least one charging module and at least one detection circuit according to any one of claims 1 to 9, wherein

the charging module comprises a charging circuit, a direct current bus, a positive bus switch, and a negative bus switch, wherein the charging circuit, the direct current bus, the positive bus switch, and the negative bus switch are connected in series; and

the detection circuit is connected to the charging module.

12. The charging pile according to claim 11, wherein in a case that the charging pile comprises a plurality of charging modules,

a power distribution switch is arranged between the charging modules; and

each of the plurality of charging modules and the power distribution switch is provided with a detection circuit.

13. The charging pile according to claim 12, wherein

For one charging module of the plurality of charging modules, a detection circuit connected to the charging module and a detection circuit corresponding to a power distribution switch connected to the charging module share a detection module.

14. The charging pile according to any one of claims 11 to 13, wherein the detection circuit does not comprises a selection switch, in a case that only adhesion detection is performed.

15. A charging station, comprising: a transformer, a system controller, and at least one charging pile according to any one of claims 11 to 14, wherein

an input side of the transformer is connected to an alternating current power grid, an output side of the transformer is connected to the charging pile; and

the system controller is connected to the charging pile, and is configured to control an operation state of the charging pile.

**FIG. 1**

**FIG. 2**

DC+        K1    Positive electrode of
                     power battery

Second detection module   20

Third detection module   30

First detection module   10

U

DC−        K2    Negative electrode
                     of power battery

**FIG. 3**

DC+        K1    Positive electrode of
                     power battery

R+

S2

First detection module   10

U

Second detection module   20

R−

Third detection module   30

DC−        K2    Negative electrode
                     of power battery

**FIG. 4**

DC+

Positive electrode of
power battery

K1

First
detection
module  10

U

S2

R+

Second
detection
module  20

R−

Third
detection
module  30

DC−

K2

Negative electrode
of power battery

**FIG. 5**

S100

Detection instruction is acquired

S110

In response to the detection instruction, the bus
switch and the detection circuit are controlled to
be in a conductive state corresponding to the
project to be detected

S120

Detection voltage of a target detection module
is acquired

S130

Detection for the project to be detected is
performed based on the detection voltage and
the connection relationship between the
detection modules in the detection circuit

**FIG. 6**

FIG. 7

FIG. 8

**FIG. 9**

**FIG. 10**

**FIG. 11**

**FIG. 12**

**FIG. 13**

**FIG. 14**

**FIG. 15**

Europäisches
Patentamt

European
Patent Office

Office européen
des brevets

# EUROPEAN SEARCH REPORT

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | EP 3 451 005 A2 (CONTEMPORARY AMPEREX TECHNOLOGY CO LTD [CN]) 6 March 2019 (2019-03-06) | 1-7,9,10 | INV. B60L53/14 H01H47/00 |
| Y | * paragraphs [0005] - [0022], [0095] - [0111]; figures 1-6 * | 8,11-15 | |
| X | EP 3 451 002 A1 (CONTEMPORARY AMPEREX TECHNOLOGY CO LTD [CN]) 6 March 2019 (2019-03-06) | 1-7,9,10 | |
| Y | * paragraphs [0003] - [0016], [0057] - [0066]; figures 1-8 * | 8,11-15 | |
| X | EP 3 683 592 A1 (CONTEMPORARY AMPEREX TECHNOLOGY CO LTD [CN]) 22 July 2020 (2020-07-22) | 1-7,9,10 | |
| Y | * paragraphs [0002] - [0010]; figures 1-13 * | 8,11-15 | |
| Y | DE 10 2006 050529 A1 (CONTI TEMIC MICROELECTRONIC [DE]) 30 April 2008 (2008-04-30) * paragraphs [0002] - [0016], [0026], [0027], [0031], [0032]; figures 1-3 * | 11-13 | TECHNICAL FIELDS SEARCHED (IPC) B60L H01H |
| Y | EP 3 624 251 A1 (LG CHEMICAL LTD [KR]) 18 March 2020 (2020-03-18) * paragraphs [0008] - [0017]; figures 1-8 * | 11-13 | |
| A | US 2019/187211 A1 (MÜLLER JENS UWE [DE] ET AL) 20 June 2019 (2019-06-20) * paragraphs [0003] - [0018]; figures 1-4 * | 1-15 | |
| A | US 2020/317076 A1 (WANG RUI [US] ET AL) 8 October 2020 (2020-10-08) * paragraphs [0003] - [0008]; figures 1-4 * | 1-15 | |

-/--

The present search report has been drawn up for all claims

| Place of search | Date of completion of the search | Examiner |
|---|---|---|
| Munich | 26 July 2022 | Krasser, Bernhard |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

page 1 of 2

**EUROPEAN SEARCH REPORT**

Application Number

EP 22 15 6395

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | WO 2020/078289 A1 (HANGZHOU POWER SUPPLY COMPANY OF STATE GRID ZHEJIANG ELECTRIC POWER [C] 23 April 2020 (2020-04-23) * paragraph [0011]; figure 4 * ----- | 15 | |
| Y | US 2018/231610 A1 (ZHOU YI [CN]) 16 August 2018 (2018-08-16) * abstract; figure 1 * ----- | 8 | |

TECHNICAL FIELDS SEARCHED (IPC)

The present search report has been drawn up for all claims

| Place of search | Date of completion of the search | Examiner |
|---|---|---|
| Munich | 26 July 2022 | Krasser, Bernhard |

EPO FORM 1503 03.82 (P04C01)

**EP 4 052 954 A1**

**ANNEX TO THE EUROPEAN SEARCH REPORT
ON EUROPEAN PATENT APPLICATION NO.** EP 22 15 6395

This annex lists the patent family members relating to the patent documents cited in the above-mentioned European search report.
The members are as contained in the European Patent Office EDP file on
The European Patent Office is in no way liable for these particulars which are merely given for the purpose of information.

26-07-2022

| Patent document cited in search report | | Publication date | Patent family member(s) | | Publication date |
|---|---|---|---|---|---|
| EP 3451005 | A2 | 06-03-2019 | CN | 107728066 A | 23-02-2018 |
| | | | EP | 3451005 A2 | 06-03-2019 |
| | | | US | 2019064279 A1 | 28-02-2019 |
| EP 3451002 | A1 | 06-03-2019 | CN | 107479002 A | 15-12-2017 |
| | | | EP | 3451002 A1 | 06-03-2019 |
| | | | US | 2019064285 A1 | 28-02-2019 |
| EP 3683592 | A1 | 22-07-2020 | CN | 109765495 A | 17-05-2019 |
| | | | EP | 3683592 A1 | 22-07-2020 |
| | | | US | 2020225275 A1 | 16-07-2020 |
| | | | WO | 2020147748 A1 | 23-07-2020 |
| DE 102006050529 A1 | | 30-04-2008 | NONE | | |
| EP 3624251 | A1 | 18-03-2020 | CN | 110537288 A | 03-12-2019 |
| | | | EP | 3624251 A1 | 18-03-2020 |
| | | | JP | 7078315 B2 | 31-05-2022 |
| | | | JP | 2020522216 A | 27-07-2020 |
| | | | KR | 20190063268 A | 07-06-2019 |
| | | | PL | 3624251 T3 | 27-12-2021 |
| | | | US | 2020112069 A1 | 09-04-2020 |
| | | | WO | 2019107979 A1 | 06-06-2019 |
| US 2019187211 | A1 | 20-06-2019 | CN | 109975695 A | 05-07-2019 |
| | | | DE | 102017223229 A1 | 19-06-2019 |
| | | | EP | 3503343 A1 | 26-06-2019 |
| | | | US | 2019187211 A1 | 20-06-2019 |
| US 2020317076 | A1 | 08-10-2020 | CN | 111806236 A | 23-10-2020 |
| | | | DE | 102020109126 A1 | 08-10-2020 |
| | | | US | 2020317076 A1 | 08-10-2020 |
| WO 2020078289 | A1 | 23-04-2020 | CN | 109455106 A | 12-03-2019 |
| | | | US | 2021237610 A1 | 05-08-2021 |
| | | | WO | 2020078289 A1 | 23-04-2020 |
| US 2018231610 | A1 | 16-08-2018 | CN | 106908719 A | 30-06-2017 |
| | | | US | 2018231610 A1 | 16-08-2018 |
| | | | WO | 2018145397 A1 | 16-08-2018 |

EPO FORM P0459

For more details about this annex : see Official Journal of the European Patent Office, No. 12/82